(19) Europäisches Patentamt
European Patent Office
Office européen des brevets

(11) **EP 4 582 173 A1**

(12) **EUROPEAN PATENT APPLICATION**
published in accordance with Art. 153(4) EPC

(43) Date of publication:
**09.07.2025 Bulletin 2025/28**

(21) Application number: **23860387.2**

(22) Date of filing: **30.08.2023**

(51) International Patent Classification (IPC):
*B01D 61/14* (2006.01)     *B01D 61/22* (2006.01)
*B01D 65/06* (2006.01)     *G03F 7/32* (2006.01)
*C02F 1/44* (2023.01)

(52) Cooperative Patent Classification (CPC):
**B01D 61/14; B01D 61/22; B01D 65/06; C02F 1/44;
G03F 7/32**

(86) International application number:
**PCT/JP2023/031392**

(87) International publication number:
**WO 2024/048625 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.09.2022 JP 2022139931**

(71) Applicant: **Asahi Kasei Kabushiki Kaisha
Tokyo 1000006 (JP)**

(72) Inventors:
• **HASEGAWA, Ryosuke
Tokyo 100-0006 (JP)**
• **YAMADA, Takashi
Tokyo 100-0006 (JP)**

(74) Representative: **Strehl & Partner mbB
Maximilianstrasse 54
80538 München (DE)**

(54) **METHOD AND DEVICE FOR TREATING AQUEOUS DEVELOPER WASTE LIQUID, AND DEVELOPMENT SYSTEM**

(57)     A treatment method for a waste aqueous development liquid generated through development of a flexographic printing original plate by using an aqueous development liquid, the method including: a first filtration step of filtering the waste aqueous development liquid at 5°C or more and 48°C or less through a microfiltration membrane to give a recovered liquid and a concentrated waste liquid; and a reuse step of reusing the recovered liquid for development of a flexographic printing original plate.

[FIG. 1]

## Description

### Technical Field

The present invention relates to a treatment method and treatment apparatus for a waste aqueous development liquid, and a developing system.

### Background Art

Printing plates with photosensitive resin can be produced with a computer-to-plate technology (hereinafter, referred to as the "CTP technology"), in which information processed on a computer is directly drawn in the form of a printing plate to make a relief. Especially, flexographic printing, a kind of relief printing, has an advantage of applicability to various substrates because soft materials such as rubbers and synthetic resins are used for printing plates.

Printing plates based on the CTP technology (in particular, flexographic printing plates) are made through a procedure in which laser drawing is performed for an infrared absorption layer on a photosensitive resin, the photosensitive resin layer is exposed to light for curing, uncured parts are developed, and the resulting plate is dried and subjected to post-exposure. Flexographic printing plates are made by performing, for example, solvent development to develop uncured parts by dissolution with solvent development liquid, or aqueous development to develop uncured parts by peeling with aqueous development liquid containing a surfactant; after performing the solvent development or aqueous development, however, waste liquid from the corresponding solution is generated. In producing solvent or aqueous development liquid, and in disposing waste development liquid therefrom by incineration, $CO_2$ is generated. From the viewpoint of environmental friendliness, reduction in the amounts of development liquid solution to be used in developing printing plates and waste development liquid to be generated has been demanded.

In the solvent development, recovery and reuse of solution after development by distillation have been common, and also for the aqueous development a method for reusing water recovered through vacuum distillation has been disclosed (e.g., see Patent Literature 1).

### Citation List

### Patent Literature

Patent Literature 1: International Publication NO. WO 2003/005129

### Summary of Invention

### Technical Problem

Aqueous waste development liquid contains development residues (e.g., resin from unexposed parts removed from a developed flexographic printing original plate), which are impurities mixed in development liquid during development, in addition to development liquid components (e.g., a surfactant). Removal of development residues is needed in reusing waste aqueous development liquid. Here, it is expected that if waste aqueous development liquid is filtered with use of a filtration membrane having a pore size larger than development liquid components and smaller than development residues, then all the development liquid components can be recovered; on the contrary, the present inventors have found a problem of simultaneous removal of development liquid components (i.e., attenuation of development liquid concentration).

Thus, an object of the present invention is to achieve enhanced recovery rates for development liquid components in filtering waste aqueous development liquid and concentrated waste liquid.

### Solution to Problem

As a result of diligent examination, the present inventors have found that enhanced recovery rates for development liquid components (e.g., a surfactant) are successfully achieved by filtering waste aqueous development liquid and concentrated waste liquid under low-temperature conditions.

The present invention includes the following embodiments.

[1] A treatment method for a waste aqueous development liquid generated through development of a flexographic printing original plate by using an aqueous development liquid, the method including:

a first filtration step of filtering the waste aqueous development liquid at 5°C or more and 48°C or less through a microfiltration membrane to give a recovered liquid and a concentrated waste liquid; and

a reuse step of reusing the recovered liquid for development of a flexographic printing original plate.

[2] The treatment method according to [1], further including a temperature control step of controlling the waste aqueous development liquid to have a temperature of 5°C or more and 43°C or less before the first filtration step.

[3] The treatment method according to [1] or [2], further including a second filtration step of repeatedly performing the first filtration step by using the concentrated waste liquid as the waste aqueous development liquid.

[4] The treatment method according to [3], wherein the concentrated waste liquid is managed to have a temperature of 5°C or more and 48°C or less during the second filtration step.

[5] The treatment method according to [3] or [4], wherein

the waste aqueous development liquid contains a surfactant, and
a passing rate of the surfactant in a total of the recovered liquid given in the first filtration step and the second filtration step is 42% or more and 95% or less.

[6] The treatment method according to [5], wherein the passing rate of the surfactant is 55% or more and 95% or less.

[7] The treatment method according to any one of [3] to [6], wherein when the concentrated waste liquid has reduced in amount below a specific reference level during the second filtration step, an additional waste aqueous development liquid is added.

[8] The treatment method according to any one of [1] to [7], wherein the concentrated waste liquid is discarded when at least one of the following (A) to (F) satisfies a specific criterion:

(A) total amount of the recovered liquid;

(B) number of addition of the additional waste aqueous development liquid to the concentrated waste liquid;

(C) total amount of the additional waste aqueous development liquid added to the concentrated waste liquid;

(D) inlet pressure of the waste aqueous development liquid or the concentrated waste liquid to the microfiltration membrane;

(E) outlet pressure of the waste aqueous development liquid or the concentrated waste liquid exiting from the microfiltration membrane; and

(F) circulation flow rate of the waste aqueous development liquid or the concentrated waste liquid toward the microfiltration membrane.

[9] The treatment method according to any one of [1] to [8], further including a washing step of washing the microfiltration membrane with an acidic aqueous solution having a pH of 3 or less.

[10] The treatment method according to [9], wherein the washing step includes:

soaking the microfiltration membrane in the acidic aqueous solution; and/or

circulating the acidic aqueous solution through the microfiltration membrane.

[11] A treatment apparatus for a waste aqueous development liquid generated through development of a flexographic printing original plate by using an aqueous development liquid, the treatment apparatus including:

a waste aqueous development liquid storage tank that stores the waste aqueous development liquid;

a filtration module including a microfiltration membrane that performs filtration of the waste aqueous development liquid; and

a recovered liquid storage tank that stores a recovered liquid generated through the filtration.

[12] The treatment apparatus according to [20], further including a circulation tank that circulates a concentrated waste liquid generated through the filtration to the filtration module.

[13] The treatment apparatus according to [21], wherein the circulation tank includes a temperature controller.

[14] A developing system including:

the treatment apparatus according to any one of [11] to [13]; and

a developing apparatus that discharges the waste aqueous development liquid through development of a flexographic printing original plate by using an aqueous development liquid.

**Advantageous Effect of Invention**

The present invention enables achievement of enhanced recovery rates for development liquid components in filtering waste aqueous development liquid and concentrated waste liquid.

**Brief Description of Drawings**

[Figure 1] Figure 1 is a schematic diagram of a developing system according to an embodiment of the present invention.

[Figure 2] Figure 2 shows a configuration for controlling filtering pressure (filtering rate).

[Figure 3] Figure 3 shows the temporal temperature variations of waste development liquid with or without temperature management.

**Description of Embodiments**

The following specifically describes embodiments of the present invention, but the present invention is not limited to the description, and various modifications can be made in a manner without departing from the gist.

<Treatment method for waste aqueous development liquid>

An embodiment of the present invention relates to a treatment method for a waste aqueous development liquid generated through development of a flexographic printing original plate by using an aqueous development liquid, the method including:

a first filtration step of filtering the waste aqueous development liquid at 5°C or more and 48°C or less through a microfiltration membrane to give a recovered liquid and a concentrated waste liquid; and

a reuse step of reusing the recovered liquid for development of a flexographic printing original plate.

**The** method according to the present embodiment enables reduction in the amount of development liquid components to be removed in filtration by filtering a waste aqueous development liquid under low-temperature conditions. Thereby, the concentration of development liquid components contained in the recovered liquid (filtrate) can be maintained, and reuse of the recovered liquid enables reduction in the amount of the development liquid to be additionally used. In addition, the reuse of the recovered liquid enables reduction in the amount of a waste liquid to be discarded. In this way, the method according to the present embodiment has great advantages in economic and environmental senses.

[Aqueous development liquid and waste aqueous development liquid]

The term "aqueous development liquid" herein refers to development liquid containing water as a solvent.

The term "waste aqueous development liquid" herein refers to aqueous development liquid that has been used for development.

The term "concentrated waste liquid" herein refers to waste liquid given through filtration of waste aqueous development liquid.

The components contained in the aqueous development liquid (development liquid components) and the components contained in the waste aqueous development liquid or concentrated waste liquid are not limited to particular kinds, and examples of the components include a surfactant, an additive, a pH adjuster, and a defoamer. In addition to the components, the waste aqueous development liquid or concentrated waste liquid further contains development residues (e.g., resin from unexposed parts removed from a developed flexographic printing original plate), which are impurities mixed in the development liquid during development.

(Surfactant)

The surfactant may be of any type without limitation, and is preferably a nonionic surfactant, an anionic surfactant, or a combination thereof.

More preferably, the nonionic surfactant is a polyalkylene glycol represented by the following formula (B1).

$$\text{Formula (B1):} \quad RO(AO)_pH$$

wherein

R is an alkyl group having 10 to 20 carbon atoms, or an aryl group,
A is an alkylene group having two to four carbon atoms, and
p is an integer of 1 to 50.

In the formula (B1),

R is preferably an alkyl group having 10 to 18 carbon atoms, or an aryl group,
A is preferably an alkylene group having two to four carbon atoms, and
p is preferably an integer of 6 to 10.

The polyalkylene glycol represented by the formula (B1) is preferably a polyoxyalkylene alkyl ether.

Preferably, the polyoxyalkylene alkyl ether is a compound represented by the following formula (B1-1) or (B1-2).

$$\text{Formula (B1-1):} \quad R^4O(CH_2CH_2O)_pH$$

$$\text{Formula (B1-2):} \quad R^4O(CH_2CH_2O)_{p1}(CH(CH_3)CH_2O)_{p2}H$$

In the formula (B1-1), $R^4$ is an alkyl group having 1 to 20 carbon atoms, and p is an integer of 1 to 50.

In the formula (B1-2), $R^4$ is hydrogen or an alkyl group having 1 to 20 carbon atoms, and the sum total of p1 and p2 is an integer of 1 to 50. The moiety - $(CH_2CH_2O)_{p1}(CH(CH_3)CH_2O)_{p2}$- may be a random polymer or a block polymer.

Commercially available products may be used for the polyoxyalkylene alkyl ether. Examples of commercially available polyoxyalkylene alkyl ether include, but are not limited to, Newcol (R) NT-3, Newcol NT-5, Newcol NT-7, Newcol NT-9, Newcol NT-12, Newcol 2302, Newcol 2303, Newcol 1203, Newcol 1204, Newcol 2303-Y, Newcol 2304-YM, Newcol 2304-Y, polyoxyethylene 2-ethylhexyl ether (Newcol 1004, Newcol 1006, Newcol 1008), polyoxyethylene tridecyl ether (Newcol 1305), Newcol 2306-Y, Newcol 2306-HY, Newcol 2308-Y, Newcol 2308-LY, Newcol 708, Newcol 709, Newcol 82, Newcol 85, Newcol 1210, and Newcol 1902-Y manufactured by NIPPON NYUKAZAI CO., LTD.

The polyalkylene glycol represented by the formula (B1) is preferably a polyoxyalkylene polycyclic phenyl ether.

Preferably, the polyoxyalkylene polycyclic phenyl ether is a compound represented by the following formula (B1-3).

$$\text{Formula (B1-3):} \quad R^4O(CH_2CH_2O)_pH$$

In the formula (B1-3), $R^4$ is polycyclic phenyl, and p is an integer of 1 to 50.

Commercially available products may be used for the polyoxyalkylene polycyclic phenyl ether. Examples of commercially available polyoxyalkylene polycyclic phenyl ether include, but are not limited to, Newcol 703, Newcol 704, and Newcol 2604.

Preferably, the anionic surfactant is an alkyl ether sulfate salt, an alkyl sulfate salt, a fatty acid salt, a linear alkylbenzenesulfonate, or a combination thereof. For example, sodium polyoxyethylene lauryl ether sulfate (e.g., SUNNOL LMT-1430 manufactured by Lion Corporation), sodium polyoxyethylene($C_{13}$) alkyl ether sulfate (e.g., SUNNOL TD-3130 manufactured by Lion Corporation), or an alkyl ether sulfate salt the alkyl group of which has 8 to 18 carbon atoms (e.g., TAYCAPOL NE1230 manufactured by TAYCA CORPORATION) may be used as the alkyl ether sulfate salt.

The amount of the surfactant contained in the waste aqueous development liquid is not limited, but the lower limit is preferably 0.01% by mass, more preferably 0.1% by mass, further preferably 1.0% by mass, and particularly preferably 1.5% by mass for higher developing rates, and the upper limit is preferably 10% by mass, and more preferably 6.0% by mass. The lower limits and upper limits can be appropriately combined to define a numerical range. For example, the amount of the surfactant contained in the waste aqueous development liquid is preferably 0.1 to 10% by mass, more preferably 1.0 to 10% by mass, even more preferably 1.0 to 6.0% by mass, and particularly preferably 1.5 to 6.0% by mass.

(Additive)

The additive may be of any type without limitation, and is preferably a compound represented by the following formula (A1) or formula (A2).

Formula (A1):       $R^1O(A^1O)_nR^2$

wherein

$R^1$ and $R^2$ are each independently an alkyl group having two to six carbon atoms or an alkenyl group having two to six carbon atoms, preferably an alkyl group having two to six carbon atoms, and more preferably an alkyl group having four carbon atoms (butyl group),
$A^1$ is an alkylene group having two to four carbon atoms, preferably an alkylene group having two or three carbon atoms, and more preferably an alkylene group having two carbon atoms ($-CH_2CH_2-$), and
n is an integer of 1 to 5, preferably an integer of 1 to 3, and more preferably 2.

Formula (A2):       $R^3O(A^2O)_mH$

wherein

$R^3$ is an alkyl group having three to eight carbon atoms or an alkenyl group having three to eight carbon atoms, preferably an alkyl group having three to eight carbon atoms, and more preferably an alkyl group having six carbon atoms (hexyl group),
$A^2$ is an alkylene group having two to four carbon atoms, preferably an alkylene group having two or three carbon atoms, and more preferably an alkylene group having two carbon atoms ($-CH_2CH_2-$), and
m is an integer of 1 to 5, preferably an integer of 1 to 3, and more preferably 2.

The amount of the compound represented by the formula (A1) and contained in the waste aqueous development liquid is not limited, but the lower limit is preferably 0.05% by mass, and more preferably 0.15% by mass for higher developing rates, and the upper limit is preferably 0.40% by mass, and more preferably 0.30% by mass. The lower limits and upper limits can be appropriately combined to define a numerical range. For example, the amount of the compound represented by the formula (A1) and contained in the waste aqueous development liquid is preferably 0.05% by mass or more and 0.40% by mass or less, and more preferably 0.15% by mass or more and 0.30% by mass or less.

The amount of the compound represented by the formula (A2) and contained in the waste aqueous development liquid is not limited, but the lower limit is preferably 0.20% by mass, and more preferably 0.25% by mass for higher developing rates, and the upper limit is preferably 0.70% by mass, and more preferably 0.60% by mass. The lower limits and upper limits can be appropriately combined to define a numerical range. For example, the amount of the compound represented by the formula (A2) and contained in the waste aqueous development liquid is preferably 0.20% by mass or more and 0.70% by mass or less, and more preferably 0.25% by mass or more and 0.60% by mass or less.

(pH adjuster)

The pH adjuster may be of any type without limitation, and is preferably an inorganic base. Examples of the inorganic base include lithium hydroxide, sodium hydroxide, potassium hydroxide, calcium hydroxide, lithium carbonate, sodium carbonate, potassium carbonate, cesium carbonate, lithium hydrogen carbonate, sodium hydrogen carbonate, potassium hydrogen carbonate, cesium hydrogen carbonate, potassium fluoride, sodium fluoride, cesium fluoride, lithium chloride, and lithium bromide.

The amount of the pH adjuster contained in the waste aqueous development liquid is not limited, but it is preferable for higher developing rates that the pH adjuster in an amount to give a pH of 9 or more and 12 or less to the waste aqueous development liquid be contained.

(Defoamer)

The defoamer may be of any type without limitation, and examples thereof include silicone compounds, and more specific examples include compounds including organomodified silicone, perfluoroalkyl group-containing silicone, and fluorine-modified silicone. Use of an emulsion-type defoamer is preferred for higher dispersibility in aqueous development liquid. Examples of commercially available products of emulsion-type defoamer include KM-73, KM-73A, KM-73E, KM-70, KM-71, KM-75, KM-7750D, KM-85, KM-89, KM-90, KM-98, KM7752, KM-72, KM-72S, KM-72GS, KM-72F, and KM-72FS manufactured by Shin-Etsu Chemical Co., Ltd.

(Development residues)

Examples of the resin constituting the photosensitive resin layer of the flexographic printing original plate include hydrophobic resins, hydrophilic resins, and combinations thereof. In using a hydrophobic resin, it is preferred to impart hydrophilicity to the hydrophobic resin. Imparting hydrophilicity to a hydrophobic resin results in easiness in developing the hydrophobic resin with aqueous development liquid.

Preferably, the main component of the resin constituting the photosensitive resin layer is, for example:

a resin resulting from modification of a hydrophobic resin with a carboxylic acid or a salt thereof;

a mixture of a hydrophobic component containing a hydrophobic resin as the main component and a hydrophilic component containing a hydrophilic resin as the main component;

a resin resulting from chemical bonding of a hydrophobic resin and a hydrophilic resin; or

a resin resulting from block copolymerization of a hydrophobic monomer to serve as a starting material for a hydrophobic resin and a hydrophilic monomer to serve as a starting material for a hydrophilic resin.

(Additional component)

The aqueous development liquid, and the waste aqueous development liquid or concentrated waste liquid may further contain an additional component such as a viscosity modifier, a stabilizer, and a fragrance.

[Steps of treatment method]

Preferably, the treatment method according to the present embodiment includes a temperature control step, a first filtration step, a second filtration step, and a reuse step. The following describes these steps.

(Temperature control step)

The temperature control step is a step of controlling the waste aqueous development liquid to have a temperature of 5°C or more and 43°C or less before the first filtration step described later.

Development of flexographic printing original plates is typically performed with development liquid heated to elevated temperature for increased developing rates, and hence the temperature of waste aqueous development liquid generated through development is also high. Because the waste aqueous development liquid is filtered at low temperature in the first filtration step, it is preferred to lower the temperature of the waste aqueous development liquid in advance.

The waste aqueous development liquid is filtered while circulating in a given apparatus in actual cases, and the temperature of the circulating waste aqueous development liquid tends to increase because of, for example, a heat source or friction in the apparatus. Accordingly, it is preferred to control the waste aqueous development liquid to have a temperature lower than a temperature required in the first filtration step. Specifically, it is preferred to lower the temperature of the waste aqueous development liquid to a temperature at least 5°C below the upper limit temperature required in the first filtration step (48°C) in view of the temperature increase rate of the circulating waste aqueous development liquid. That is, in the temperature control step, the waste aqueous development liquid is controlled to have a temperature of 5°C or more and 43°C or less, preferably of 5°C or more and 35°C or less, more preferably of 5°C or more and 30°C or less. The reason why 5°C or more is preferred is that the freezing of the waste aqueous development liquid is prevented.

Examples of methods to control the temperature of the waste aqueous development liquid include, but are not limited to, a method of leaving the waste aqueous development liquid to stand for natural heat radiation, a method of performing heat exchange, and a method of directly cooling. The method of leaving the waste aqueous development liquid to stand is preferred for reduction in electric power consumption and $CO_2$ emissions. In leaving to stand for natural heat radiation, it is preferred for avoiding contamination in the circulation tank of the membrane filtration apparatus to provide a waste aqueous development liquid storage tank that temporarily stores the waste development liquid.

(First filtration step)

The first filtration step is a step of filtering the waste aqueous development liquid at 5°C or more and 48°C or less through a microfiltration membrane (MF membrane) to give a recovered liquid and a concentrated waste liquid.

Enhanced recovery rates for development liquid components can be achieved through the filtration of the waste aqueous development liquid under low-temperature conditions. Thus, the temperature of the waste aqueous development liquid in the first filtration step is 5°C or more and 48°C or less, preferably 5°C or more and 43°C or less, and more preferably 5°C or more and 40°C or less. Improved recovery rates for the surfactant can be achieved through filtration of the waste aqueous development liquid in that temperature range. The lower limit of the temperature is for the purpose of preventing the freezing of the waste aqueous development liquid.

Preferably, the first filtration step is performed by means of a crossflow method with a hollow-fiber membrane as a filtration membrane. Examples of commercially available hollow-fiber membranes include Microza (R) MF Modules USW-543 (nominal pore size: 0.1 μm), UMW-553 (nominal pore size: 0.2 μm), USP-343 (nominal pore size: 0.1 μm), UMP-353 (nominal pore size: 0.2 μm), ULW-348 (nominal pore size: 0.45 μm), and UTP-6443 (nominal pore size: 0.2 μm) manufactured by Asahi Kasei Corporation, <PUREAR (R)> ML MLE-7101 (1210) (nominal pore size: 0.1 μm) and MLE-7101H (1210) (nominal pore size: 0.1 μm) manufactured by Kuraray Co., Ltd., and POREFLON (R) Module-01B25 (nominal pore size: 0.08 μm), -11B50 (nominal pore size: 0.08 μm), -11B70 (nominal pore size: 0.08 μm), -11B110 (nominal pore size: 0.08 μm), -02B25 (nominal pore size: 0.1 μm), -12B50 (nominal pore size: 0.1 μm), -12B70 (nominal pore size: 0.1 μm), and -12B100 (nominal pore size: 0.1 μm) manufactured by Sumitomo Electric Industries, Ltd. Employing the crossflow method results in achievement of high filtering rates (amount of recovered liquid given per unit time) maintained with the clogging of the membrane in filtration prevented.

Setting the pressure in the inlet side of the filtration membrane to be higher than the pressure in the outlet side thereof is preferred for giving much recovered liquid. Preferably, the circulation flow velocity of the waste aqueous development liquid toward the membrane module in filtration is 1.3 m/sec or more for preventing the clogging of the membrane in filtration to maintain high filtering rates (amount of recovered liquid given per unit time).

(Second filtration step)

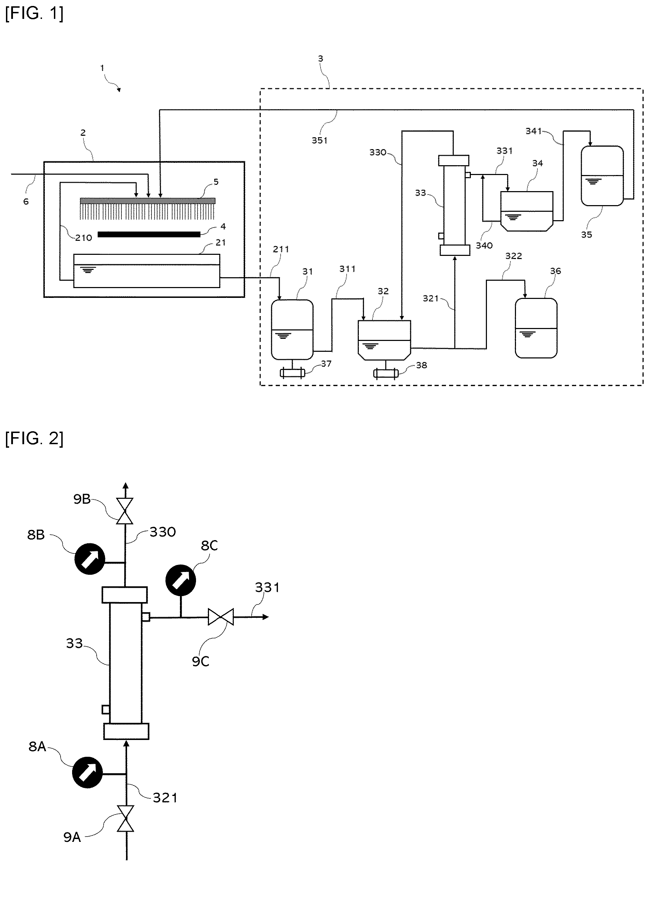

The second filtration step is a step of repeatedly performing the first filtration step by using the concentrated waste liquid obtained in the first filtration step as the waste aqueous development liquid. For example, in the case that the waste aqueous development liquid is circulated between a circulation tank 32 and a filtration module 33 as in a developing system shown in Figure 1, a phase until a waste aqueous development liquid in the same amount as the waste aqueous development liquid initially contained in the circulation tank 32 has been filtered in the filtration module 33 is referred to as the first filtration step, and filtration after that until the concentrated waste liquid is discarded is referred to as the second filtration step.

In the second filtration step, repeated filtration of the concentrated waste liquid allows more recovered liquid to be given simultaneously with reduction in the amount of the concentrated waste liquid.

Since the temperature of the concentrated waste liquid circulating in the apparatus tends to increase because of, for example, a heat source or friction in the apparatus as described above, it is preferred for enhanced recovery rates for development liquid components to manage the concentrated waste liquid to have a temperature of 5°C or more and 48°C or less (preferably 5°C or more and 43°C or less, more preferably 5°C or more and 40°C or less) during the second filtration step.

The manner of temperature management is not limited to a particular method; for example, the temperature of the concentrated waste liquid can be directly checked, and lowered if necessary. Examples of methods for lowering the temperature include, but are not limited to, a method of leaving the concentrated waste liquid to stand for natural heat radiation (temporarily suspending the filtration), a method of performing heat exchange, and a method of directly cooling. The heat exchange or direct cooling may be performed in parallel with the filtration step. Alternatively, the temperature of the concentrated waste liquid may be lowered by adding an additional waste aqueous development liquid whose temperature has been lowered in the temperature control step.

**In** place of directly checking the temperature of the concentrated waste liquid, temperature management may be performed on the basis of the amount of the concentrated waste liquid as an indirect index. Specifically, the temperature of the concentrated waste liquid may be lowered on the assumption that the temperature of the circulating concentrated waste liquid comes to exceed a specific temperature when the amount of the concentrated waste liquid has fallen below a specific reference level.

As the amount of the concentrated waste liquid decreases, the viscosity increases and the feeding rate of the concentrated waste liquid to the filtration membrane decreases. Hence, temperature management may be performed on the basis of the feeding rate of the concentrated waste liquid as an indirect index.

As the amount of the concentrated waste liquid decreases, the viscosity increases and the inlet pressure of the concentrated waste liquid to the filtration membrane increases. Hence, temperature management may be performed on the basis of the inlet pressure of the concentrated waste liquid as an indirect index.

The "temperature management" in the present invention includes a method of completing filtration before the temperature of the concentrated waste liquid unwantedly exceeds the scope of the present invention by increasing the filtering rate (amount of recovered liquid given per unit time). Specifically, because the increase of the temperature of the concentrated waste liquid is generally in proportion to the filtration time, the temperature increase of the concentrated waste liquid can be reduced by shortening the filtration time.

In addition, for example, completing filtration before the waste liquid temperature unwantedly exceeds the upper limit value by sufficiently decreasing the temperature of the waste liquid before filtration in the temperature adjustment step, or increasing the filtering rate, or a combination of these is included in the "temperature management" in the present specification. In this case, performing temperature regulation, such as natural heat radiation, heat exchange, and direct cooling, with the filtration suspended is not necessarily needed. The manner of increasing the filtering rate is as described later, and the filtering rate may be adjusted to a sufficient filtering rate before filtration, or appropriately adjusted during filtration on a case-by-case basis.

One or more of all of the "temperature management" methods described above may be freely combined and used.

The passing rate of the surfactant contained in the waste aqueous development liquid is preferably 34% or more, more preferably 42% or more, and even more preferably 55% or more. The passing rate being 34% or more results in an effect to reduce the amount of usage of development liquid, and the passing rate being 55% or more results in an effect to reduce the $CO_2$ emission. The reduction of $CO_2$ refers to such a state that comparison between the amount of $CO_2$ reduction achieved by reuse of recovered liquid (i.e., reduction in the amount of usage of development liquid and reduction in the amount of discharged waste development liquid) and the amount of $CO_2$ emission based on the amount of electric energy consumed in performing the method according to the present embodiment (the amount of $CO_2$ emission generated in electric power generation) shows that the amount of $CO_2$ reduction exceeds the amount of $CO_2$ emission.

The passing rate of the surfactant is preferably 95% or less, and more preferably 90% or less. The passing rate being 95% or less leads to a result that the surfactant is sufficiently contained even in a concentrated waste liquid given after filtration, and as a result the aggregation of resin in the concentrated waste liquid is prevented and the breakdown of the membrane filtration apparatus can be avoided.

The passing rate of the surfactant is preferably 42% or more and 95% or less, more preferably 55% or more and 95% or less, and even more preferably 55% or more and 90% or less.

The passing rate of the surfactant is calculated from the following expression.

Passing rate = [concentration of surfactant in recovered liquid/concentration of surfactant in waste development liquid] × 100

The passing rate is calculated for the total recovered liquid given in a period from the start of the first filtration step to the end of the second filtration step (i.e., a combination of a plurality of recovered liquids given in the first filtration step and the second filtration step). The passing rate in this case indicates the ratio of the concentration of the surfactant in the total recovered liquid given in a period from the start of the first filtration step to the end of the second filtration step to the concentration of the surfactant in the waste development liquid before filtration in the first filtration step.

The passing rate is affected not only by the temperature of the waste development liquid but also by the clogging of the filtration membrane, etc. Specifically, as the clogging of the filtration membrane grows, the passing rate tends to decrease. Accordingly, when the passing rate has fallen below the lower limit shown above, it is preferred to maintain the passing rate within a desired range, for example, by performing a washing step described later.

However, it is not common in the membrane filtration method to increase the filtering rate. This is because excessively high filtering rates allow the progression of the clogging of the membrane with development residues even in the case that the crossflow method is employed, resulting in significantly lowered filtering rates over time to make repeated use impossible. Through the progression of the clogging of the membrane, the development residues causing the clogging trap development liquid components including the surfactant to decrease the passing rates of development liquid components in the filtration step. This causes the need of concentration adjustment by adding a huge amount of the development liquid before reusing the recovered liquid. That is, high filtering rates have a trade-off relationship with the lifetime of the hollow-fiber membrane and the passing rates of development liquid components, and hence it is common to employ an operation method to reduce the filtering rate, for example, by constricting the piping for the recovered liquid with a valve (filtration valve) or the like.

For filtering rates enhanced in combination with the lifetime of the hollow-fiber membrane (prevention of clogging) and passing rates of development liquid components, the present inventors have invented a washing technique for hollow-fiber membranes. The washing method according to the present invention enables repeated use with high filtering rates and passing rates of development liquid components maintained without causing the clogging of the hollow-fiber membrane, even when the waste aqueous development liquid and the concentrated waste liquid are filtered at high filtering rates. Thereby, the temperature increase of the concentrated waste liquid during filtration can be prevented, and higher recovery efficiency for development liquid components are successfully given.

Examples of methods for increasing filtering rates include increasing the pressure (filtering pressure) applied by the waste aqueous development liquid or concentrated waste liquid to the hollow-fiber membrane (a specific adjustment method is described later). In practical cases, mechanical upper limit values according to the material and shape of a membrane module to be used are preset to filtering pressure and pressure values associated with filtering pressure, and hence they are to be adjusted below the upper limit values. As a method for maintaining high filtering rates with clogging prevented, a devised operation method can be applied to the filtration step in addition to a washing method described later for the hollow-fiber membrane.

As the concentrated waste liquid is repeatedly filtered in the second filtration step, the concentration of development residues contained in the concentrated waste liquid gradually increases to lead to higher probability of the occurrence of clogging in the filtration membrane. Accordingly, it is preferred to discard the concentrated waste liquid (terminating the filtration step) at an opportune time. For example, the concentrated waste liquid may be discarded when at least one of the following (A) to (F) satisfies a specific criterion:

(A) total amount of the recovered liquid;

(B) number of addition of the additional waste aqueous development liquid to the concentrated waste liquid;

(C) total amount of the additional waste aqueous development liquid added to the concentrated waste liquid;

(D) inlet pressure of the waste aqueous development liquid or the concentrated waste liquid to the filtration membrane;

(E) outlet pressure of the waste aqueous development liquid or the concentrated waste liquid exiting from the filtration membrane; and

(F) circulation flow rate (L/min) of the waste aqueous development liquid or the concentrated waste liquid circulating toward the filtration membrane.

For example, the reached concentration ratio can be calculated by using value (A) and value (B) or (C), and thus the filtration step can be terminated when a desired concentration ratio is reached. **If** the concentrated waste liquid undergoes considerably higher viscosity increase than expected for some reasons, the inlet pressure of the concentrated waste liquid to the filtration membrane (D) increases, the outlet pressure on the filtration membrane (E) decreases, and the circulation flow rate (F) decreases before a desired concentration ratio is reached, and hence the filtration step can be terminated without excessively loading the filtration membrane and thus clogging can be prevented by completing the filtration step when monitoring of them finds that any of them satisfies a specific criterion.

It is preferred in doing such an operation to use a system that monitors at least one of the above (A) to (F) (e.g., only A, A + B, A + C, only D, only E, only F, or any combination of D to F) to determine whether it has satisfied a specific criterion.

The present invention can achieve higher recovery efficiency (passing rates) for development liquid components (e.g., a surfactant) by filtering the waste aqueous development liquid or the concentrated waste liquid at low temperature. Since waste aqueous development liquid discharged from developing apparatuses has high temperature, the filtration step can be initiated after cooling. In the filtration, temperature management can be performed with at least one of the temperature management methods described above or a combination of a plurality of such methods. Increased filtering rates lead to achievement of shorter filtration time, and the temperature increase of the concentrated waste liquid can be reduced. While the filtration membrane undergoes gradual reduction in the filtering rate, wherein the reduction is caused by clogging derived from development residues through raising the filtering rate and repeated use, use of the method for washing the filtration membrane according to the present invention and/or the above-described method for terminating the filtration step inhibits the progression of clogging and enables repeated use of the filtration membrane with keeping a high filtering rate. The filtering rate is preferably 8.5 L/hr·m$^2$ or more, more preferably 10 L/hr·m$^2$ or more, and even more preferably 11.5 L/hr·m$^2$ or more, but is not limited thereto. For completing the concentration in a timely manner through monitoring of the reached concentration ratio, pressure gauges, the circulation flow rate of the concentrated waste liquid, and so on, the upper limit of the filtering rate is preferably 50 L/hr·m$^2$ or less, and more preferably 45 L/hr·m$^2$ or less. The unit L/hr·m$^2$ is defined as the amount of recovered liquid given per unit area of the hollow-fiber membrane per unit time of filtration.

(Reuse step)

The reuse step is a step of reusing the recovered liquid given in the first filtration step and/or the second filtration step for development of a flexographic printing original plate.

Since the concentrations of development liquid components contained in the recovered liquid are lower than those in the aqueous development liquid, it is preferred to add a development liquid component (e.g., at least one component selected from the group consisting of water, a surfactant, an additive, and a pH adjuster) in reusing the recovered liquid for development.

The development liquid component to be added (e.g., at least one component selected from the group consisting of water, a surfactant, an additive, and a pH adjuster) may be directly added to the recovered liquid, or added to the aqueous development liquid mixed with the recovered liquid.

(Washing step)

The washing step is a step of washing the filtration membrane with an acidic aqueous solution having a pH of 3 or less.

Washing the filtration membrane is preferred because development residues attach to the filtration membrane through the first filtration step and the second filtration step, causing clogging to lower the filtering rate. Preferably, the washing step is performed after the end of the second filtration step, as necessary. However, the frequency or interval for washing is not limited; for example, the washing step may be performed when reduction in the filtering rate has been found.

For removal of development residues, the pH of the acidic aqueous solution is 3 or less, preferably 2.5 or less, and more preferably 2 or less. The pH of 3 or less allows particles of development residues attaching to the filtration membrane to have large absolute values of zeta potential, the particles repel each other and the particle sizes become smaller, and as a result the particles are removed and the clogging is eliminated.

The acid contained in the acidic aqueous solution may be of any type without limitation, and examples thereof include inorganic acids (e.g., phosphoric acid, nitric acid, hydrochloric acid, sulfuric acid), organic acids (e.g., acetic acid, formic acid, citric acid, oxalic acid), and mixtures of any of them.

Examples of washing methods include, but are not limited to, a method of soaking the filtration membrane in the acidic aqueous solution, and a method of circulating the acidic aqueous solution through the filtration membrane.

In the washing step, the filtration membrane may be backwashed with use of the recovered liquid. The term backwash means flowing the recovered liquid in a direction reverse to the flow direction of the waste aqueous development liquid or concentrated waste liquid in the first and second filtration steps to remove development residues attaching to the filtration membrane. The backwash may be performed during filtration; for example, backwash can be performed with the obtained recovered liquid while the circulation of the concentrated waste liquid is temporarily suspended (the first and second filtration steps are suspended). At that time, the time interval for filtration/backwash can be freely determined; for example, a cycle of 10-minute filtration/10-second backwash may be repeated.

<Treatment apparatus for waste aqueous development liquid and developing system>

An embodiment of the present invention relates to a treatment apparatus for a waste aqueous development liquid generated through development of a flexographic printing original plate by using an aqueous development liquid, the treatment apparatus including:

a waste aqueous development liquid storage tank that stores the waste aqueous development liquid;

a filtration module including a microfiltration membrane that performs filtration of the waste aqueous development liquid; and

a recovered liquid storage tank that stores a recovered liquid generated through the filtration.

The treatment apparatus may further include a circulation tank that circulates a concentrated waste liquid generated through the filtration to the filtration module. The circulation tank may include a temperature controller.

The waste aqueous development liquid storage tank may include a temperature controller. In the case that the waste aqueous development liquid storage tank includes no temperature controller, the temperature of the waste aqueous development liquid may be lowered by leaving the waste aqueous development liquid to stand for natural heat radiation in the waste aqueous development liquid storage tank.

An embodiment of the present invention relates to a developing system including: the treatment apparatus; and a developing apparatus that discharges the waste aqueous development liquid through development of a flexographic printing original plate by using an aqueous development liquid.

The following describes the treatment apparatus and developing system according to the embodiments of the present invention with reference to drawings; however, the configurations of the treatment apparatus and developing system are not limited to the described ones.

Figure 1 illustrates a developing system 1. The developing system 1 includes a developing apparatus 2 and a treatment apparatus 3.

The developing apparatus 2 includes: a development liquid tank 21 that stores an aqueous development liquid; and a brush 5 that brushes a surface of a flexographic printing original plate 4.

In the developing apparatus 2, a surface of the flexographic printing original plate 4 is brushed with the brush 5 while the aqueous development liquid stored in the development liquid tank 21 is fed to the flexographic printing original plate 4 via a return pipe 210. Development residues removed from the flexographic printing original plate 4 return to the development liquid tank 21 together with the aqueous development liquid. Every time a new flexographic printing original plate is developed, the aqueous development liquid is fed to the development liquid tank 21 via a delivery pipe 6, as necessary, and an excessive portion of the aqueous development liquid over a specific amount (waste aqueous development liquid) is sent from the development liquid tank 21 to a waste aqueous development liquid storage tank 31 via a delivery pipe 221.

The treatment apparatus 3 includes: a waste aqueous development liquid storage tank 31 that stores the waste aqueous development liquid; a filtration module 33 including a microfiltration membrane that performs filtration of the waste aqueous development liquid; and a recovered liquid storage tank 35 that stores a recovered liquid generated through the filtration. Details of the filtration membrane are as described in the section (First filtration step).

The treatment apparatus 3 may further include a circulation tank 32 that circulates a concentrated waste liquid to the filtration module 33.

The treatment apparatus 3 may further include a filtrate tank 34 that sends a recovered liquid generated through the filtration back to the filtration module 33 or sends the recovered liquid to the recovered liquid storage tank 35.

The treatment apparatus 3 may further include a concentrated waste liquid storage tank 36 that stores a concentrated waste liquid to be discarded.

The treatment apparatus 3 may further include a temperature controller 37 that controls (lowers) the temperature of the waste aqueous development liquid stored in the waste aqueous development liquid storage tank 31. The treatment apparatus 3 may further include a temperature controller 38 that controls (lowers) the temperature of the concentrated waste liquid stored in the circulation tank 32. The temperature controller may be of any type without limitation, and examples thereof include a heat exchanger, a direct-cooling chiller, and a heat pump.

In the treatment apparatus 3, the waste aqueous development liquid stored in the waste aqueous development liquid storage tank 31 is subjected to temperature control, as necessary, and then sent to the circulation tank 32 via a delivery pipe 311. The waste aqueous development liquid stored in the circulation tank 32 is sent to the filtration module 33 via a delivery pipe 321, and filtered.

The filtration module 33 gives a recovered liquid and a concentrated waste liquid, and the concentrated waste liquid is sent back to the circulation tank 32 via a return pipe 330. The concentrated waste liquid sent back to the circulation tank 32 is sent again to the filtration module 33 via a delivery pipe 321, and thus circulates between the circulation tank 32 and the filtration module 33. After the circulation of the concentrated waste liquid between the circulation tank 32 and the filtration module 33 is repeated, the concentrated waste liquid is sent to the concentrated waste liquid storage tank 36 via a delivery pipe 322.

The waste aqueous development liquid storage tank 31 included in the treatment apparatus 3 prevents the waste aqueous development liquid from being stored in the entire of the treatment apparatus 3 for a long time, and thus the contamination in the treatment apparatus 3 is successfully prevented. The treatment apparatus 3 may include two or more (preferably two) waste aqueous development liquid storage tanks 31. This configuration allows the temperature of the waste aqueous development liquid in one waste aqueous development liquid storage tank 31 to be controlled while the temperature-controlled waste aqueous development liquid stored in the other waste aqueous development liquid storage tank 31 is filtered, thus enabling efficient operations.

The circulation tank 32 may include a liquid level gauge (not shown). When the amount of the concentrated waste liquid in the circulation tank 32 is measured with a liquid level gauge and found to have fallen below a specific reference level, an additional waste aqueous development liquid may be fed from the waste aqueous development liquid storage tank 31 to the circulation tank 32 to lower the temperature of the concentrated waste liquid. In the case that 200 L of the waste aqueous development liquid is to be filtered and concentrated into 50 L (4-fold concentration), for example, filtration is initiated after feeding only 100 L of the waste aqueous development liquid into the circulation tank 32, and 100 L of the residual waste aqueous development liquid can be fed once or in multiple portions into the circulation tank 32 when the liquid volume in the circulation tank 32 has fallen below a specific reference level.

The delivery pipe 321 and/or return pipe 330 may include a pressure gauge (not shown). When the pressure of the concentrated waste liquid passing through the delivery pipe 321 and/or return pipe 330 is measured and found to satisfy a specific criterion, the filtration step may be completed to send the concentrated waste liquid to the concentrated waste liquid storage tank 36 on the assumption that the concentrated waste liquid has been sufficiently concentrated (or the waste liquid viscosity has exceeded a reference level). The delivery pipe 321 and/or return pipe 330 may include a flow rate gauge (not shown). When the flow rate [L/min] of the concentrated waste liquid passing through the delivery pipe 321 and/or return pipe 330 is measured and found to satisfy a specific criterion (having fallen below a specific reference level), the filtration step may be completed to send the concentrated waste liquid to the concentrated waste liquid storage tank 36 on the assumption that the concentrated waste liquid has been sufficiently concentrated (or the waste liquid viscosity has exceeded a reference level).

The recovered liquid given by the filtration module 33 is sent to the filtrate tank 34 via a delivery pipe 331. The recovered liquid stored in the filtrate tank 34 is sent back to the filtration module 33 via a return pipe 340, as necessary, and the filtration module 33 is washed (backwashed). The recovered liquid stored in the filtrate tank 34 is sent to the recovered liquid storage tank 35 via a delivery pipe 341.

The delivery pipe 321 may include a pressure gauge 8A and a valve 9A, as illustrated in Figure 2. The return pipe 330 may include a pressure gauge 8B and a valve 9B. The delivery pipe 331 may include a pressure gauge 8C and a valve 9C. Here, let the inlet pressure of the concentrated waste liquid to the filtration module 33 Pi (the pressure measured with the pressure gauge 8A), the outlet pressure Po (the pressure measured with the pressure gauge 8B), and the discharging pressure of the recovered liquid Pf (the pressure measured with the pressure gauge 8C), the filtering pressure is expressed as {(Pi + Po) / 2} - Pf.

For example, the filtering rate can be increased by opening the valve 9C, which lowers Pf to increase the filtering pressure. In addition, the filtering rate can be increased by opening the valve 9A, which raises Pi to increase the filtering pressure. Furthermore, the filtering rate can be increased by closing the valve 9B, which raising Po to increase the filtering pressure. A preferred filtering pressure is 0.03 MPa or more, and a more preferred filtering pressure is 0.04 MPa or more. For preventing the breakdown by reducing physical loading to the membrane, the filtering pressure is preferably 0.5 Mpa or less, and more preferably 0.4 MPa or less. As described above, the filtration can be completed before the temperature of the concentrated waste liquid exceeds a specific reference level by increasing the filtering rate.

The recovered liquid stored in the recovered liquid storage tank 35 is supplemented with development liquid components, as necessary, and then sent to the developing apparatus 2 via a delivery pipe 351, and reused.

**Examples**

The following describes the present invention in more detail with Examples and Comparative Examples, but the technical scope of the present invention is not limited thereto.

Apparatuses used in Examples and Comparative Examples are as follows.

- Developing apparatus: AWP (TM)-DEW 4260 PLF manufactured by Asahi Kasei Corporation

- Filtration module: Microza MF Module UMP-153 (nominal pore size: 0.2 $\mu$m) or UMP-353 (nominal pore size: 0.2 $\mu$m) manufactured by Asahi Kasei Corporation

Aqueous development liquids used in Examples and Comparative Examples contain the following components.

Development liquid A

- Solvent (water)
- Surfactant (product name: Newcol NT-7, manufactured by NIPPON NYUKAZAI CO., LTD.)
- Surfactant (product name: Newcol NT-9, manufactured by NIPPON NYUKAZAI CO., LTD.)
- Additive (diethylene glycol dibutyl ether (DBDG))
- Additive (diethylene glycol monohexyl ether (HeDG))

- pH adjuster (potassium carbonate)

Development liquid B

- Solvent (water)
- Surfactant (product name: SUNNOL LMT-1430, manufactured by Lion Corporation)

Washing agents (products) used in Examples and Comparative Examples are as follows.

- ULTRASIL 75 manufactured by Ecolab Inc.

- ULTRASIL MP manufactured by Ecolab Inc.

- ULTRASIL 115 manufactured by Ecolab Inc.

<Recovery Test 1>

A waste aqueous development liquid obtained by developing 119 flexographic printing original plates (AWP (TM)-DEW (1.14 mm, BL size)) in total with the developing apparatus into which aqueous development liquid A had been loaded was used in examples and a comparative example. The concentrations of components contained in the waste aqueous development liquid are shown in Table 1.

[Example 1]

The waste aqueous development liquid, controlled to have a temperature of 20°C, was subjected to repeated crossflow filtration using the filtration module UMP-153 (the first filtration step and second filtration step described above were performed) to give a recovered liquid in an amount of 80 vol% of the waste aqueous development liquid (16 L of a recovered liquid and 4 L of a concentrated waste liquid were obtained from 20 L of the waste aqueous development liquid). At that time, the inlet pressure of the waste aqueous development liquid, Pi, was set to 0.06 Mpa, the outlet pressure, Po, to 0.04 Mpa, the discharging pressure, Pf, to 0.01 Mpa, and the circulation velocity of the waste aqueous development liquid to 2 m/sec. The concentrations, recovery rates, and passing rates of components contained in the recovered liquid are shown in Tables 1 to 3. Each recovery rate refers to the proportion of the mass of a component contained in the recovered liquid to the mass of the component contained in the waste aqueous development liquid. Each passing rate refers to the proportion of the concentration of a component contained in the recovered liquid to the concentration of the component contained in the waste aqueous development liquid. The concentrations of components in the waste aqueous development liquid were measured for a sample from the waste liquid before filtration, and those in the recovered liquid were measured for a sample from a mixed liquid of all the liquids obtained through the above-described filtration (first filtration step and second filtration step). The measurement method was as follows.
First, for the additives DBDG and HeDG, development residues and the like were removed with a membrane filter of 0.8 $\mu$m in pore size (25CS080AN manufactured by ADVANTEC TOYO KAISHA, LTD.), and the resulting clear liquid was subjected to quantitative analysis by gas chromatography to determine the concentrations. For the surfactants, the waste development liquid was weighed before and after evaporation to dryness to determine the nonvolatile contents, from which the concentration of the surfactants in % by mass was calculated. Specifically, first, a certain volume of the waste development liquid was collected, removed of development residues through filtration with a membrane filter of 0.8 $\mu$m in pore size (25CS080AN manufactured by ADVANTEC TOYO KAISHA, LTD.), and then the weight, W1, was measured. Next, the waste development liquid was subjected to evaporation to dryness in a thermostatic chamber at 40°C, and then the weight of nonvolatile components, W2, was measured, and (W2 / W1) $\times$ 100 was calculated. This value was used as surfactant concentration for the waste development liquid and recovered liquid obtained by using development liquid B, and that value minus the DBDG and HeDG concentrations determined with the above method was used as surfactant concentration for the waste development liquid and recovered liquid obtained by using development liquid A.

[Example 2]

The waste aqueous development liquid, controlled to have a temperature of 40°C with other filtration conditions set to the same ones as in Example 1, was filtered with the filtration module to give a recovered liquid in an amount of 80 vol% of the waste aqueous development liquid. The concentrations, recovery rates, and passing rates of components contained in the recovered liquid are shown in Tables 1 to 3.

[Comparative Example 1]

The waste aqueous development liquid, controlled to have a temperature of 50°C, was filtered with the filtration module to give a recovered liquid in an amount of 80 vol% of the waste aqueous development liquid. The concentrations, recovery rates, and passing rates of components contained in the recovered liquid are shown in Tables 1 to 3.

[Table 1]

|  | Development residues (% by mass) | Surfactant (% by mass) | HeDG (% by mass) | DBDG (% by mass) |
|---|---|---|---|---|
| Waste aqueous development liquid | 3.2 | 3.8 | 0.47 | 0.24 |
| Recovered liquid (20°C) | 0 | 2.1 | 0.32 | 0.15 |
| Recovered liquid (40°C) | 0 | 1.6 | 0.26 | 0.11 |
| Recovered liquid (50°C) | 0 | 1.2 | 0.22 | 0.09 |

[Table 2]

|  | Surfactant (% by mass) | HeDG (% by mass) | DBDG (% by mass) |
|---|---|---|---|
| Recovery rate (20°C) (% by mass) | 44.0 | 54.5 | 50.7 |
| Recovery rate (40°C) (% by mass) | 33.5 | 44.3 | 37.2 |
| Recovery rate (50°C) (% by mass) | 25.1 | 37.5 | 30.4 |

[Table 3]

|  | Surfactant (% by mass) | HeDG (% by mass) | DBDG (% by mass) |
|---|---|---|---|
| Passing rate (20°C) (% by mass) | 55 | 68 | 63 |
| Passing rate (40°C) (% by mass) | 42 | 55 | 46 |
| Passing rate (50°C) (% by mass) | 31 | 47 | 38 |

The results in Table 2 found that the relationship between temperature and recovery rates was able to be dealt with as a linear model without any problem. Linear regression expressions were determined with assuming the temperature of the waste aqueous development liquid as an explanatory variable, X, and recovery rates as a response variable, Y; the resulting expressions were as follows.

$$\text{Surfactant: } Y = -0.6131X + 56.676$$

$$\text{HeDG: } Y = -0.5595X + 65.92$$

$$\text{DBDG: } Y = -0.6755X + 64.175$$

It is understood from the resulting expressions that all the recovery rates of the surfactant and additives (HeDG, DBDG) reach 27% or more when the temperature of the waste aqueous development liquid is 48°C or less. It is understood that preferred recovery rates of 30% or more are achieved at 43°C or less, and that more preferred recovery rates of 32% or more are achieved at 40°C or less.

<Recovery Test 2>

A waste aqueous development liquid obtained by developing 34 flexographic printing original plates (AWP (TM)-DEW (1.14 mm, BL size)) in total with the developing apparatus into which aqueous development liquid B had been loaded was used in examples and comparative examples. The concentrations of components contained in the waste aqueous development liquid are shown in Table 4.

[Example 3]

The waste aqueous development liquid, controlled to have a temperature of 15°C, was subjected to repeated crossflow filtration using a filtration module (UMP-153) (the first filtration step and second filtration step described above were performed) to give a recovered liquid in an amount of 80 vol% of the waste aqueous development liquid (16 L of a recovered liquid and 4 L of a concentrated waste liquid were obtained from 20 L of the waste aqueous development liquid). At that time, the inlet pressure of the waste aqueous development liquid, Pi, was set to 0.06 Mpa, the outlet pressure, Po, to 0.04 Mpa, the discharging pressure, Pf, to 0.01 Mpa, and the circulation velocity of the waste aqueous development liquid to 2 m/sec. The concentrations, recovery rates, and passing rates of components contained in the recovered liquid are shown in Tables 4 to 6.

[Example 4]

The waste aqueous development liquid, controlled to have a temperature of 28°C with other filtration conditions set to the same ones as in Example 3, was filtered with the filtration module to give a recovered liquid in an amount of 80 vol% of the waste aqueous development liquid. The concentrations, recovery rates, and passing rates of components contained in the recovered liquid are shown in Tables 4 to 6.

[Example 5]

The waste aqueous development liquid, controlled to have a temperature of 48°C, was filtered with the filtration module to give a recovered liquid in an amount of 80 vol% of the waste aqueous development liquid. The concentrations, recovery rates, and passing rates of components contained in the recovered liquid are shown in Tables 4 to 6.

[Table 4]

|  | Development residues (% by mass) | Surfactant (% by mass) |
|---|---|---|
| Waste aqueous development liquid | 1.06 | 0.30 |
| Recovered liquid (15°C) | 0 | 0.23 |
| Recovered liquid (28°C) | 0 | 0.20 |
| Recovered liquid (48°C) | 0 | 0.17 |

[Table 5]

|  | Surfactant (% by mass) |
|---|---|
| Recovery rate (15°C) (% by mass) | 60.3 |
| Recovery rate (28°C) (% by mass) | 53.4 |
| Recovery rate (48°C) (% by mass) | 45.0 |

[Table 6]

|  | Surfactant (% by mass) |
|---|---|
| Passing rate (15°C) (% by mass) | 75 |
| Passing rate (28°C) (% by mass) | 67 |
| Passing rate (48°C) (% by mass) | 56 |

<Temperature management for waste development liquid>

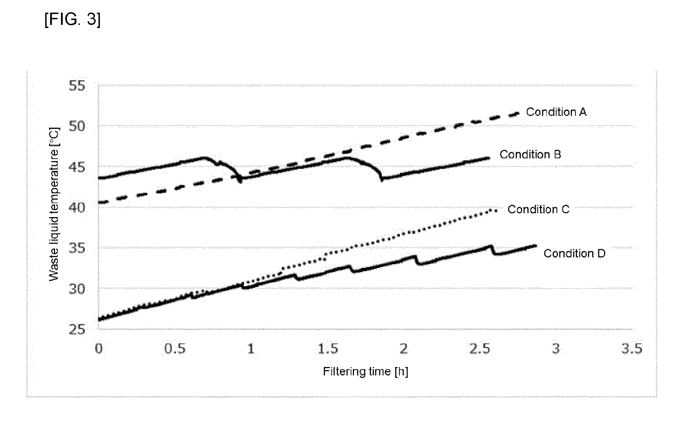

Next, 125 flexographic printing original plates (AWP (TM)-DEW (1.14 mm, BL size)) in total were developed while development liquid A was temperature-adjusted within the range of 40 to 45°C in the tank of the developing apparatus, giving waste aqueous development liquid A, which was examined for temperature variation when the waste development liquid (120 L) was subjected to crossflow filtration using a filtration module (UMP-353 (nominal pore size: 0.2 $\mu$m)) under different conditions shown below. At that time, the inlet pressure of the waste aqueous development liquid, Pi, was set to 0.09 Mpa, the outlet pressure, Po, to 0.01 Mpa, the discharging pressure, Pf, to 0.03 Mpa, and the circulation velocity of the waste aqueous development liquid to 2 m/sec. Figure 3 shows the results. As demonstrated in Figure 3, without temperature management for the waste development liquid, the temperature increased over time and exceeded 48°C.

(Condition A)

Without temperature management (waste aqueous development liquid A discharged from the developing apparatus was immediately subjected to crossflow filtration).

(Condition B)

Waste aqueous development liquid A discharged from the developing apparatus was immediately subjected to crossflow filtration, the filtration was suspended when the waste liquid temperature reached 46°C, and the filtration was restarted after the waste liquid temperature decreased to reach 43°C.

(Condition C)

The waste liquid temperature was lowered before the initiation of filtration.

(Condition D)

The waste liquid temperature was lowered before the initiation of filtration, and an additional waste liquid (20 L) having lowered temperature was added every time 20 L of a recovered liquid was obtained.

<Reuse of waste development liquid>

Waste development liquids A and B, which were the same as those used in Recovery Experiment 1 and Recovery Experiment 2 described above, were subjected to crossflow filtration using the filtration module UMP-353 (nominal pore size: 0.2 $\mu$m) at various temperatures to give recovered liquids (75% of each waste liquid was recovered), which were reused and evaluated; the results are shown in Tables 7 and 8. During the filtration, the inlet pressure of each waste aqueous development liquid, Pi, was set to 0.09 Mpa, the outlet pressure, Po, to 0.01 Mpa, the discharging pressure, Pf, to 0.03 Mpa, and the circulation velocity of each waste aqueous development liquid to 2 m/sec. In examples shown in the tables with "Temperature management" being "present", any one of natural cooling of the waste liquid before the filtration, adjustment of the filtering rate, addition of the waste liquid during the filtering steps, and use of a temperature-controlling device (installed in the circulation tank 32), or a combination of two or more of them was carried out. In examples with "Temperature management" being "absent", the high-temperature waste liquid discharged from the developing apparatus was immediately subjected to crossflow filtration, and the temperature management was not carried out during filtration, either. The waste development liquid and the recovered liquid were collected from the circulation tank 32 before the initiation of filtration and from the filtrate tank 34 after the end of filtration, respectively, to measure the surfactant concentrations, and the passing rate was calculated. To prevent the clogging of the filtration module due to overconcentration, the amount of the waste development liquid fed to the circulation tank 32 and the total amount of the obtained recovered liquid were monitored during filtration, and the filtration step was terminated to discharge the concentrated waste liquid when a concentration ratio of 4-fold was reached (75% of the waste liquid was recovered). In addition, operation was performed in such a manner that the inlet pressure, Pi, of the concentrated waste liquid to the filtration module was monitored not to exceed 0.15 Mpa (an interlock was provided to terminate the filtration on exceedance of Pi). After adding the surfactant and water to the resulting recovered liquid for concentration adjustment, the resultant was returned to the developing apparatus and development test was carried out.
"Separation of development residues" shows whether the filtration of the waste development liquid was successful or not. "A" indicates that the filtration of the waste development liquid was successful. "B" indicates that the filtration of the waste development liquid was not successful.
"Amount of additional development liquid" shows the amount of the surfactant required to be added to the recovered liquid for development with the recovered liquid. This is defined as the ratio of the amount of the surfactant added to the recovered liquid to the amount of the surfactant contained in a fresh development liquid commonly used (a common development liquid without any recovered liquid, being a new liquid before use for development; referring to fresh development liquid A or B before performing development in Recovery Experiments 1 and 2). For example, in the case that the amount of the surfactant (total of NT-7 and NT-9, ratio: 1:1) in 200 L of fresh development liquid A before development is 8 kg (concentration: 4%) and 2 kg of the surfactant (total of NT-7 and NT-9, ratio: 1:1) is added to 160 L of the resulting recovered liquid, this is expressed as $2 \times 100/8 = 25\%$. After addition of the surfactant, water was added so that the volume of the recovered liquid reached 200 L, and then development test was carried out. In the development test, first, a flexographic original plate was subjected to back exposure to cure the base in such a manner that the thickness of the resin in uncured parts reached 0.6 mm (relief depth). Thereafter, development test was carried out for proper development time for the above-described fresh development liquids (development time to give a relief depth of 0.6 mm) to check the presence or absence of unevenness (incomplete development) by visual inspection for the plate surface. Different amounts of the additional surfactant were tested in order of 25%, 35%, and 45%, and a case that unevenness was absent with 25% or more was rated as "25%", a case that unevenness was absent with 35% or more as "35%", a case that unevenness was absent with 45% as "45%", and a case that unevenness was observed even when the proportion of the added surfactant was 45% as "B", and determined as failure in giving an effect to reduce the amount of usage of development liquid.

"CFP" shows the presence or absence of a $CO_2$-reducing effect. "A" indicates the presence of a CO2-reducing effect. "B" indicates the absence of a $CO_2$-reducing effect. The presence or absence of a $CO_2$-reducing effect was estimated with considering the electric power consumed in the operation of the filtration apparatus and the reductions of usage of development liquid and waste development liquid. The calculation of electric power consumption and usage of development liquid was based on $CO_2$ emission factors in an IDEA database provided by the National Institute of Advanced Industrial Science and Technology. The $CO_2$ emissions for discarding waste development liquid were calculated on the assumption of complete combustion of substances contained in waste development liquid.

It is understood that managing the waste liquid temperature in the first and second filtration steps at 5°C or more and 48°C or less together with preventing the clogging of the membrane module allows separation of development residues and reuse of recovered liquid (reduction in the amount of usage of development liquid). In particular, cases with passing rates of 42% or more and 95% or less are preferred because the amount of usage of development liquid can be reduced by 65%. Furthermore, cases with passing rates of 55% or more are more preferred because the amount of usage of development liquid can be reduced by 75% and in addition a CO2-reducing effect is obtained.

[Table 7]

| Waste development liquid | A | A | A | A | A | A | A | A |
|---|---|---|---|---|---|---|---|---|
| Temperature in first filtration step | 1°C | 15°C | 20°C | 40°C | 20°C | 48°C | 20°C | 40°C |
| Temperature in second filtration step | - | 15~27°C | 20°C | 40°C | 20~38°C | 48°C | 20~48°C | 40~58°C |
| Temperature management | present | present | present | present | present | present | present | absent |
| Passing rate | - | 59% | 55% | 42% | 45% | 34% | 39% | 26% |
| Separation of development residues | B(frozen) | A | A | A | A | A | A | A |
| Amount of additional development liquid | - | 25% | 25% | 35% | 35% | 45% | 45% | B |
| CFP | - | A | A | B | B | B | B | B |

[Table 8]

| Waste development liquid | B | B | B |
|---|---|---|---|
| Temperature in first filtration step | 0.5°C | 28°C | 48°C |
| Temperature in second filtration step | - | 28°C | 48°C |
| Temperature management | present | present | present |
| Passing rate | - | 67% | 56% |
| Separation of development residues | B(frozen) | A | A |

(continued)

| Waste development liquid | B | B | B |
|---|---|---|---|
| Amount of additional development liquid | - | 25% | 25% |
| CFP | - | A | A |

<Washing Test 1>

ULTRASIL 75 and ULTRASIL MP were serially diluted to prepare washing solutions. The filtration module (UMP-153) after filtration of waste aqueous development liquid was performed 26 times (filtration of approximately 520 L in total) was charged with a washing solution and left to stand for 3 days, and then the inner surface of the hollow-fiber membrane was observed with a SEM. A secondary electron image (magnification: ×5000) was observed by using a VHX-D510 manufactured by KEYENCE CORPORATION with the acceleration voltage set to 5 kV. As shown in Table 9, the results of washing depended on the pH of a washing solution; development residues were successfully removed at pH 2.9 or less and recovered filtering rates resulted; on the other hand, development residues were not successfully removed at pH 3.7.

When alkaline ULTRASIL 115 was used, development residues were not successfully removed irrespective of concentration.

[Table 9]

| | Concentration | pH | Result of washing |
|---|---|---|---|
| ULTRASIL 75 | 2% | 1.2 | A |
| | 1% | 1.5 | A |
| | 0.5% | 1.6 | A |
| | 0.2% | 1.8 | A |
| ULTRASIL MP | 1.5% | 2.8 | A |
| | 0.75% | 2.9 | A |
| | 0.15% | 3.7 | B |
| A: Condition such that deposits derived from development residues on the membrane surface were removed and pores were visible B: Condition such that deposits were not removed and pores were invisible | | | |

<Washing Experiment 2>

Waste development liquid A was obtained during development of 50 to 125 flexographic printing original plates (AWP (TM)-DEW (1.14 mm, BL size)) with the developing apparatus into which aqueous development liquid A had been loaded, and subjected to crossflow filtration using a filtration module (UMP-153) 20 times in total (filtration of approximately 400 L in total). In one cycle of filtration experiment, a recovered liquid in an amount of 80 vol% of the waste aqueous development liquid was obtained (16 L of a recovered liquid and 4 L of a concentrated waste liquid were obtained from 20 L of the waste aqueous development liquid). At that time, the inlet pressure of the waste aqueous development liquid, Pi, was set to 0.06 Mpa, the outlet pressure, Po, to 0.04 Mpa, the discharging pressure, Pf, to 0.01 Mpa, and the circulation velocity of the waste aqueous development liquid to 2 m/sec. Observation of the appearance of the membrane of the filtration module after the end of the 20th filtration found black coloring, in contrast to that at the first filtration (new-product state), which was determined to indicate a clogged state, and soak washing was performed with 1% ULTRASIL 75 solution for 3 days. The passing rate of the surfactant was examined for the new-product, clogged, and washed states (Table 10). Used was the same evaluation method for passing rates as in the waste development liquid reuse experiment described above.

[Table 10]

| Development liquid | A | A | A |
|---|---|---|---|
| Temperature in first filtration step | 20°C | 20°C | 20°C |
| Temperature in second filtration step | 20°C | 20°C | 20°C |

(continued)

| Development liquid | A | A | A |
|---|---|---|---|
| Temperature management | present | present | present |
| State of filtration module | new product | clogged | washed |
| Passing rate [%] | 58 | 42 | 61 |

It is understood from Table 10 that elimination of a clogged state is preferred because high passing rates can be achieved.

**Reference Signs List**

| | |
|---|---|
| 1 | developing system |
| 2 | developing apparatus |
| 3 | treatment apparatus |
| 4 | flexographic printing original plate |
| 5 | brush |
| 21 | development liquid tank |
| 31 | waste aqueous development liquid storage tank |
| 32 | circulation tank |
| 33 | filtration module |
| 34 | filtrate tank |
| 35 | recovered liquid storage tank |
| 36 | concentrated waste liquid storage tank |
| 37, 38 | temperature controller |
| 6, 211, 311, 321, 322, 331, 341, 351 | delivery pipe |
| 210, 330, 340 | return pipe |
| 8A, 8B, 8C | pressure gauge |
| 9A, 9B, 9C | valve |

**Claims**

1. A treatment method for a waste aqueous development liquid generated through development of a flexographic printing original plate by using an aqueous development liquid, the method comprising:

   a first filtration step of filtering the waste aqueous development liquid at 5°C or more and 48°C or less through a microfiltration membrane to give a recovered liquid and a concentrated waste liquid; and
   a reuse step of reusing the recovered liquid for development of a flexographic printing original plate.

2. The treatment method according to claim 1, further comprising a temperature control step of controlling the waste aqueous development liquid to have a temperature of 5°C or more and 43°C or less before the first filtration step.

3. The treatment method according to claim 1 or 2, further comprising a second filtration step of repeatedly performing the first filtration step by using the concentrated waste liquid as the waste aqueous development liquid.

4. The treatment method according to claim 3, wherein the concentrated waste liquid is managed to have a temperature of 5°C or more and 48°C or less during the second filtration step.

5. The treatment method according to claim 3, wherein

   the waste aqueous development liquid contains a surfactant, and
   a passing rate of the surfactant in a total of the recovered liquid given in the first filtration step and the second filtration step is 42% or more and 95% or less.

6. The treatment method according to claim 5, wherein the passing rate of the surfactant is 55% or more and 95% or less.

7. The treatment method according to claim 4, wherein

the waste aqueous development liquid contains a surfactant, and
a passing rate of the surfactant in a total of the recovered liquid given in the first filtration step and the second filtration step is 42% or more and 95% or less.

8. The treatment method according to claim 7, wherein the passing rate of the surfactant is 55% or more and 95% or less.

9. The treatment method according to claim 3, wherein when the concentrated waste liquid has reduced in amount below a specific reference level during the second filtration step, an additional waste aqueous development liquid is added.

10. The treatment method according to claim 3, wherein the concentrated waste liquid is discarded when at least one of the following (A) to (F) satisfies a specific criterion:

(A) total amount of the recovered liquid;
(B) number of addition of the additional waste aqueous development liquid to the concentrated waste liquid;
(C) total amount of the additional waste aqueous development liquid added to the concentrated waste liquid;
(D) inlet pressure of the waste aqueous development liquid or the concentrated waste liquid to the microfiltration membrane;
(E) outlet pressure of the waste aqueous development liquid or the concentrated waste liquid exiting from the microfiltration membrane; and
(F) circulation flow rate of the waste aqueous development liquid or the concentrated waste liquid toward the microfiltration membrane.

11. The treatment method according to claim 6, wherein the concentrated waste liquid is discarded when at least one of the following (A) to (F) satisfies a specific criterion:

(A) total amount of the recovered liquid;
(B) number of addition of the additional waste aqueous development liquid to the concentrated waste liquid;
(C) total amount of the additional waste aqueous development liquid added to the concentrated waste liquid;
(D) inlet pressure of the waste aqueous development liquid or the concentrated waste liquid to the microfiltration membrane;
(E) outlet pressure of the waste aqueous development liquid or the concentrated waste liquid exiting from the microfiltration membrane; and
(F) circulation flow rate of the waste aqueous development liquid or the concentrated waste liquid toward the microfiltration membrane.

12. The treatment method according to claim 8, wherein the concentrated waste liquid is discarded when at least one of the following (A) to (F) satisfies a specific criterion:

(A) total amount of the recovered liquid;
(B) number of addition of the additional waste aqueous development liquid to the concentrated waste liquid;
(C) total amount of the additional waste aqueous development liquid added to the concentrated waste liquid;
(D) inlet pressure of the waste aqueous development liquid or the concentrated waste liquid to the microfiltration membrane;
(E) outlet pressure of the waste aqueous development liquid or the concentrated waste liquid exiting from the microfiltration membrane; and
(F) circulation flow rate of the waste aqueous development liquid or the concentrated waste liquid toward the microfiltration membrane.

13. The treatment method according to claim 3, further comprising a washing step of washing the microfiltration membrane with an acidic aqueous solution having a pH of 3 or less.

14. The treatment method according to claim 4, further comprising a washing step of washing the microfiltration membrane with an acidic aqueous solution having a pH of 3 or less.

15. The treatment method according to claim 6, further comprising a washing step of washing the microfiltration membrane with an acidic aqueous solution having a pH of 3 or less.

16. The treatment method according to claim 8, further comprising a washing step of washing the microfiltration membrane with an acidic aqueous solution having a pH of 3 or less.

17. The treatment method according to claim 13, wherein the washing step includes:

   soaking the microfiltration membrane in the acidic aqueous solution; and/or
   circulating the acidic aqueous solution through the microfiltration membrane.

18. The treatment method according to claim 15, wherein the washing step includes:

   soaking the microfiltration membrane in the acidic aqueous solution; and/or
   circulating the acidic aqueous solution through the microfiltration membrane.

19. The treatment method according to claim 16, wherein the washing step includes:

   soaking the microfiltration membrane in the acidic aqueous solution; and/or
   circulating the acidic aqueous solution through the microfiltration membrane.

20. A treatment apparatus for a waste aqueous development liquid generated through development of a flexographic printing original plate by using an aqueous development liquid, the treatment apparatus comprising:

   a waste aqueous development liquid storage tank that stores the waste aqueous development liquid;
   a filtration module including a microfiltration membrane that performs filtration of the waste aqueous development liquid; and
   a recovered liquid storage tank that stores a recovered liquid generated through the filtration.

21. The treatment apparatus according to claim 20, further comprising a circulation tank that circulates a concentrated waste liquid generated through the filtration to the filtration module.

22. The treatment apparatus according to claim 21, wherein the circulation tank includes a temperature controller.

23. A developing system comprising:

   the treatment apparatus according to any one of claims 20 to 22; and
   a developing apparatus that discharges the waste aqueous development liquid through development of a flexographic printing original plate by using an aqueous development liquid.

[FIG. 1]

[FIG. 2]

[FIG. 3]

# EP 4 582 173 A1

## INTERNATIONAL SEARCH REPORT

International application No.

**PCT/JP2023/031392**

| A. | CLASSIFICATION OF SUBJECT MATTER |
|---|---|

***B01D 61/14***(2006.01)i; ***B01D 61/22***(2006.01)i; ***B01D 65/06***(2006.01)i; ***G03F 7/32***(2006.01)i; ***C02F 1/44***(2023.01)i
FI: C02F1/44 F; B01D61/14 500; B01D61/22; B01D65/06; G03F7/32

According to International Patent Classification (IPC) or to both national classification and IPC

| B. | FIELDS SEARCHED |
|---|---|

Minimum documentation searched (classification system followed by classification symbols)

B01D53/22; B01D61/00-71/82; C02F1/44; G03F7/32

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 11-212275 A (TOYO BOSEKI) 06 August 1999 (1999-08-06) | 1-12, 20-23 |
|   | claims, paragraphs [0015]-[0028], [0034], examples, drawings |   |
| Y | claims, paragraphs [0015]-[0028], [0034], examples, drawings | 13-19 |
| Y | WO 2019/216326 A1 (ASAHI KASEI KABUSHIKI KAISHA) 14 November 2019 (2019-11-14) | 13-19 |
|   | claims, paragraph [0047] |   |
| A | US 2010/0213128 A1 (BRADFORD, David C.) 26 August 2010 (2010-08-26) | 1-23 |
|   | claims, figures |   |
| A | JP 2021-21890 A (ASAHI KASEI KABUSHIKI KAISHA) 18 February 2021 (2021-02-18) | 1-23 |
|   | claims, drawings |   |
| A | JP 2012-210568 A (KURITA WATER IND LTD) 01 November 2012 (2012-11-01) | 1-23 |
|   | claims, drawings |   |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 October 2023** | **07 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** |  |
|  | Telephone No. |

Form PCT/ISA/210 (second sheet) (January 2015)

25

## INTERNATIONAL SEARCH REPORT
### Information on patent family members

International application No.

**PCT/JP2023/031392**

| Patent document cited in search report | | | Publication date (day/month/year) | Patent family member(s) | | | Publication date (day/month/year) |
|---|---|---|---|---|---|---|---|
| JP | 11-212275 | A | 06 August 1999 | (Family: none) | | | |
| WO | 2019/216326 | A1 | 14 November 2019 | US | 2021/0229037 | A1 | |
| | | | | claims, paragraph [0159] | | | |
| | | | | CN | 112074338 | A | |
| US | 2010/0213128 | A1 | 26 August 2010 | WO | 2010/098819 | A1 | |
| | | | | EP | 2401061 | A1 | |
| JP | 2021-21890 | A | 18 February 2021 | (Family: none) | | | |
| JP | 2012-210568 | A | 01 November 2012 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2003005129 A